# EUROPÄISCHE PATENTSCHRIFT

(11) **EP 3 370 888 B1**
(45) Veröffentlichungstag und Bekanntmachung des Hinweises auf die Patenterteilung: **22.04.2020**
(21) Anmeldenummer: 16785116.1
(22) Anmeldetag: 19.10.2016
(51) Int. Cl.: B08B 5/04, C23F 1/08, H05K 3/00, H05K 3/06, H01L 21/67, H01L 21/677

(54) **BEHANDLUNGSFLUID-ABSAUGVORRICHTUNG UND DIESE ENTHALTENDE ÄTZVORRICHTUNG**
TREATMENT FLUID SUCTION DEVICE AND ETCHING APPARATUS USING THIS DEVICE
DISPOSITIF D'ASPIRATION D'UN LIQUIDE DE TRAITMENT ET APPAREIL DE GRAVURE UTILISANT CE DISPOSITIF

(30) Priorität: 04.11.2015 DE 102015221646
(43) Veröffentlichungstag der Anmeldung: 12.09.2018
(73) Patentinhaber: Gebr. Schmid GmbH, 72250 Freudenstadt (DE)
(72) Erfinder: HAUNGS, Jürgen, 72250 Freudenstadt (DE); RAPP, Stefan, 72250 Freudenstadt (DE)
(74) Vertreter: Patentanwälte Ruff, Wilhelm, Beier, Dauster & Partner mbB
(86) Internationale Anmeldenummer: PCT/EP2016/075029
(87) Internationale Veröffentlichungsnummer: WO 2017/076640

(56) Entgegenhaltungen:
- WO-A1-2013/187036
- WO-A1-2014/069711
- WO-A1-2014/167682
- JP-A- S5 825 479
- JP-A- 2008 034 436
- JP-A- 2012 140 677
- TW-A- 201 106 821
- US-A1- 2012 103 521

## Beschreibung

Die Erfindung bezieht sich auf eine Absaugvorrichtung zum Absaugen eines Behandlungsfluids von einer im Wesentlichen planen Behandlungsoberfläche von mittels Transportwalzen entlang einer im Wesentlichen horizontalen Transportrichtung transportierten Behandlungssubstraten, wobei die Absaugvorrichtung eine Saugquelle, eine diese ansteuernde Absaugsteuereinheit und eine an die Saugquelle angeschlossene Absaugrohreinheit mit wenigstens einer Absauglanze aufweist, die mit einer oder mehreren eintrittsseitigen Absaugdüsenöffnungen in einem Absaugabstand zur Behandlungsoberfläche positionierbar ist. Die Erfindung bezieht sich außerdem auf eine mit einer solchen Absaugvorrichtung ausgerüstete Ätzvorrichtung zum nasschemischen Ätzen einer im Wesentlichen planen Behandlungsoberfläche von Behandlungssubstraten mittels eines Ätzfluids, wobei die Ätzvorrichtung darüber hinaus mindestens ein Ätzmodul mit einem Ätzfluidreservoir sowie Ätzfluidfördermittel zum Fördern des Ätzfluids vom Ätzfluidreservoir zur Behandlungsoberfläche und eine Transporteinheit mit Transportwalzen zum Transportieren der Behandlungssubstrate entlang einer im Wesentlichen horizontalen Transportrichtung beinhaltet und die Absaugvorrichtung zum Absaugen des Ätzfluids von der Behandlungsoberfläche eingerichtet ist. Derartige Ätzvorrichtungen werden beispielsweise zum nasschemischen Oberflächenätzen von Leiterplatten, Leiterfolien oder Halbleiterwafer eingesetzt.

Die Offenlegungsschrift DE 41 21 032 A1 offenbart eine Vorrichtung zum Behandeln von plattenförmigen Gegenständen mit einem fluiden Behandlungsmedium entlang eines im Wesentlichen horizontalen Transportweges, wobei das Behandlungsmedium mittels einer Auftragsvorrichtung oder mittels einer stehenden Welle auf eine zu behandelnde Oberfläche aufgebracht wird. In Transportrichtung gesehen vor oder nach dem Auftragsort des Behandlungsmediums sind Absaugrohre mit Absaugöffnungen angeordnet, die der zu behandelnden Oberfläche zugewandt sind und sich im Wesentlichen über die gesamte Breite des Transportweges erstrecken. Durch diese Anordnung der Absaugöffnungen kann der behandelte Oberflächenbereich, der zum Behandlungszeitpunkt mit dem Behandlungsmedium in Kontakt steht, in seiner Ausdehnung längs der Transportrichtung definiert und begrenzt werden. Die Absaugrohre beinhalten jeweils eine Saugdüse, wobei die Saugdüsen an einen Behälter zur Abtrennung von abgesaugten Flüssigkeits- und Luftanteilen angekoppelt sind, der seinerseits an eine Vakuumpumpe angeschlossen ist, die den Unterdruck für die Saugdüsen bereitstellt.
Eine weitere Absaugvorrichtung der eingangs genannten Art ist in Verwendung bei einer Vorrichtung zur Sprühbehandlung von Leiterplatten in der Offenlegungsschrift DE 100 39 558 A1 offenbart. Die dortige Absaugeinrichtung umfasst eine Saugdüsenanordnung zum Absaugen eines aufgesprühten Behandlungsfluids von einer Oberseite der Leiterplatten während des Besprühvorgangs sowie eine fluidbetriebene Ejektoreinrichtung zur Erzeugung des Unterdrucks für die Saugdüsenanordnung, wobei die Ejektoreinrichtung vorzugsweise in einem Vorratsbehältnis angeordnet ist, in welchem das Behandlungsfluid bevorratet ist, und von einem mit einer Umwälzpumpe ausgestatteten Umwälzkreis für das Behandlungsfluid gespeist wird. Die Ejektoreinrichtung kann insbesondere mit Venturidüsen ausgestattet sein.
Die Offenlegungsschrift DE 30 22 146 A1 offenbart eine Absaugvorrichtung für plattenförmige Gegenstände, wie mit einem flüssigen Medium vorbehandelte und von Bohrungen durchsetzte Leiterplatten, mit einem an ein Sauggebläse anschließbaren Saugkopf, der mindestens einen an seinen Enden geschlossenen Saugschlitz aufweist, an dem die Gegenstände mittels einer Fördervorrichtung quer zu dessen Längsrichtung vorbeibewegbar sind. Um die Saugleistung zu optimieren, ist eine Saugschlitzabdeckung vorgesehen, die eine Vielzahl von Abdeckelementen umfasst, welche voneinander unabhängig zwischen einer den Saugschlitz im entsprechenden Bereich abdeckenden oder freigebenden Stellung bewegbar sind, wobei sie durch Vorbeilauf des jeweiligen Gegenstandes in die freigebende Offenstellung steuerbar sind und nach dem Vorbeilauf des Gegenstandes selbsttätig in die abdeckende Stellung zurückkehren.

Die Dokumente JP2008-034436-A und WO2014/167682-A1 offenbaren ebenfalls Absaugvorrichtungen für Leiterplatten welche mit einer Ätzflüssigkeit behandelt werden.

Der Erfindung liegt als technisches Problem die Bereitstellung einer Absaugvorrichtung der eingangs genannten Art zugrunde, die ein für entsprechende Anwendungen verbessertes Absaugen von Behandlungsfluid ermöglicht und bei Verwendung in einer Ätzvorrichtung dazu beitragen kann, den Ätzprozess zu verbessern. Der Erfindung liegt zudem die Bereitstellung einer entsprechend verbesserten Ätzvorrichtung zugrunde.

Die Erfindung löst dieses Problem durch die Bereitstellung einer Absaugvorrichtung mit den Merkmalen des Anspruchs 1 und einer Ätzvorrichtung mit den Merkmalen des Anspruchs 10.

Erfindungsgemäß sind die Saugquelle und die Absaugsteuereinheit der Absaugvorrichtung auf einen Saugvolumenstrom pro Absauglanze von mindestens 30m³/h und einen Saug-Unterdruck von nicht mehr als 8kPa ausgelegt. Mit dem Begriff Saug-Unterdruck ist hierbei vorliegend der Differenz-Unterdruck zur umgebenden Atmosphäre zu verstehen. Verglichen mit typischerweise für die vorliegenden Einsatzzwecke verwendeten Absaugvorrichtungen ist damit die erfindungsgemäße Absaugvorrichtung dafür eingerichtet, einen signifikant höheren Saugvolumenstrom und einen signifikant geringeren Differenzdruck zum Absaugen des Behandlungsfluids bereitzustellen. Das Behandlungsfluid wird folglich mit dieser Absaugvorrichtung primär über einen vergleichsweise hohen Volumenstrom und nicht wie bei den üblichen herkömmlichen Absaugvorrichtungen primär über einen hohen Differenz-Unterdruck abgesaugt. Dies bietet gute Voraussetzungen für ein verbessertes Absaugverhalten und in Anwendung bei Ätzvorrichtungen für einen verbesserten Ätzprozess.

Der relativ hohe Saugvolumenstrom pro Absauglanze, der z.B. auch im Bereich von 200m³/h bis 300m³/h liegen kann, und der relativ niedrige Differenzdruck, der z.B. auch bei nur 2kPa bis 3kPa liegen kann, bewirken entsprechend hohe Strömungsgeschwindigkeiten an den Absaugdüsenöffnungen, so dass die Absaugvorrichtung über das Prinzip der Strömungsgeschwindigkeit arbeitet und die Saugleistung durch unterschiedliche Medien mit unterschiedlichen Dichten, wie Luft und Behandlungsfluid, nicht signifikant beeinträchtigt wird. Die Verwendung eines vergleichsweise geringen Differenzdrucks verringert zudem die Gefahr, dass das Behandlungssubstrat an der Absauglanze anhaftet.

In einer Weiterbildung der Erfindung weist die Absauglanze der erfindungsgemäßen Absaugvorrichtung eine kammartige Absaugstruktur mit einem Absaugsammelrohr und mehreren von diesem kammartig abgehenden Absaugrohren auf, an denen eintrittsseitig die Absaugdüsenöffnungen vorgesehen sind. Diese kammartige Absaugstruktur bietet in entsprechenden Anwendungsfällen ein deutlich verbessertes Absaugverhalten, indem das auf die Behandlungsoberfläche aufgebrachte Behandlungsfluid sehr gleichmäßig und effektiv von dieser wieder abgesaugt werden kann. Besonders vorteilhaft können die beiden Erfindungsaspekte auf Wunsch miteinander kombiniert sein.

Für Anwendungen, bei denen die jeweilige Transportwalze mit im Abstand voneinander auf ihr angeordneten Transportrollen versehen ist, ist eine Weiterbildung der Erfindung vorteilhaft, bei der sich die Absaugrohre der kammartigen Absaugstruktur vom Absaugsammelrohr aus in Zwischenräume zwischen den Transportrollen der Transportwalze hinein erstrecken. Dadurch kann das Behandlungsfluid in einem Bereich sehr nahe der betreffenden Transportwalze abgesaugt werden, was für eine gute und gleichmäßige Absaugung des Behandlungsfluids günstig sein kann.

In einer weiteren Ausgestaltung dieser Maßnahme enden die Absaugrohre mit ihren Absaugdüsenöffnungen im Absaugabstand zur Behandlungsoberfläche über einem unteren Niveau der Transportrollen und in einer durch eine Drehachse der Transportwalze gehenden Vertikalebene oder um höchstens 10mm von dieser Vertikalebene beabstandet. Diese Anordnung der Absaugdüsenöffnungen ist in vielen Fällen deutlich günstiger als deren Anordnung in einem Bereich zwischen zwei aufeinanderfolgenden Transportwalzen.

In einer weiteren Ausgestaltung dieser Maßnahme enden die Absaugrohre mit ihren Absaugdüsenöffnungen in einem Abstand von höchstens 7mm über einem unteren Niveau der Transportrollen. Dies bedeutet, dass sich die Absaugdüsenöffnungen im Bereich eines tiefsten Punktes der Transportrollen oder jedenfalls nur relativ geringfügig über diesem tiefsten Niveau der Transportrollen befinden, wodurch sich das Absaugverhalten der Absaugvorrichtung weiter optimieren lässt.

In einer Weiterbildung der Erfindung umfasst die Saugquelle einen Radialventilator oder einen Seitenkanalverdichter. Saugquellen dieses Typs erweisen sich als für die vorliegende Absaugvorrichtung besonders günstig, da sich mit ihnen recht problemlos der erwähnt hohe Saugvolumenstrom bei nur mäßigem Differenz-Unterdruck bereitstellen lässt.

In einer Weiterbildung der Erfindung ist die Saugquelle der Absaugvorrichtung mit einem Spülleitungseingang und einem Spülleitungsausgang in eine Spülleitung eingeschleift. Dies erlaubt bei Bedarf ein einfaches Spülen der Saugquelle, um sie z.B. von Resten des abgesaugten Behandlungsfluids zu reinigen.

In einer Weiterbildung der Erfindung beinhaltet die Absaugvorrichtung einen Behandlungsmedium-Sammeltank, der an einem Eingang mit der wenigstens einen Absauglanze und an einem Ausgang mit der Saugquelle verbunden ist und einen effektiven Strömungsquerschnitt aufweist, der größer als ein effektiver Strömungsquerschnitt der darin einmündenden wenigstens einen Absauglanze ist. Letzteres ermöglicht es, dass die Absauggeschwindigkeit im Bereich des Sammeltanks deutlich abfällt, was das Sammeln bzw. Abscheiden des Behandlungsmediums aus dem Saugstrom unterstützt. So kann im Sammeltank das flüssige Behandlungsmedium vom gasförmigen Saugstromanteil getrennt werden.

In einer Ausgestaltung dieser Maßnahme ist das Absaugsammelrohr der jeweiligen Absauglanze mit einem Gefälle in Richtung des Behandlungsmedium-Sammeltanks angeordnet. Dies unterstützt den Transport des von der Behandlungsoberfläche abgesaugten Behandlungsfluids in Richtung Sammeltank.

Die erfindungsgemäße Ätzvorrichtung ist mit der erfindungsgemäßen Absaugvorrichtung ausgerüstet und ermöglicht dadurch entsprechend vorteilhafte Ätzprozesse.

In einer Weiterbildung der Erfindung ist der Ätzfluid-Sammeltank der in der Ätzvorrichtung vorgesehenen Absaugvorrichtung auf einem Niveau über dem Reservoir des Ätzfluids angeordnet, und eine Rückführleitung führt vom Ätzfluid-Sammeltank zum Ätzfluidreservoir. Dadurch kann abgesaugtes Ätzfluid durch Schwerkraft selbsttätig wieder vom Sammeltank in das Reservoir zurückgelangen.

Vorteilhafte Ausführungsformen der Erfindung sind in den Zeichnungen dargestellt und werden nachfolgend beschrieben. Hierbei zeigen:
- Fig. 1: eine schematische Blockdiagrammdarstellung einer Ätzvorrichtung zum nasschemischen Ätzen von im Wesentlichen planen Behandlungssubstraten,
- Fig. 2: eine detailliertere schematische Perspektivseitenansicht der Ätzvorrichtung von Figur 1 in einem Substratbehandlungsbereich,
- Fig. 3: eine schematische Draufsicht auf den Bereich einer Transportwalze von Fig. 2,
- Fig. 4: eine ausschnittweise Perspektivseitenansicht eines Substratbehandlungsbereichs ähnlich demjenigen von Fig. 2 und
- Fig. 5: eine Detailansicht von Fig. 4 unter Weglassen einer Transportwalze.

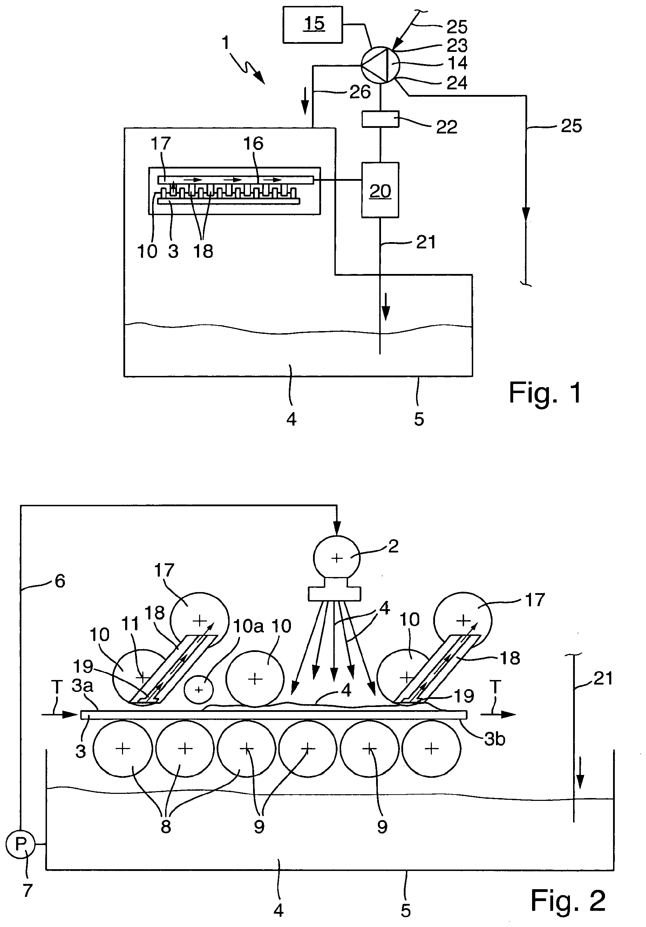

In den Fig. 1 bis 5 sind eine Ätzvorrichtung und eine in diese integrierte Absaugvorrichtung in einer exemplarischen Realisierung der Erfindung veranschaulicht. In der gezeigten Ausführungsform beinhaltet die Ätzvorrichtung ein oder mehrere Ätzmodule 1, wobei das jeweilige Ätzmodul 1 mindestens eine Sprüh-, Schwall- oder Hybridätzeinheit 2 oberhalb eines Transportniveaus aufweist, auf welchem zu behandelnde Substrate 3 transportiert werden. Bei den zu behandelnden Substraten 3 kann es sich insbesondere um Leiterplatten, Leiterfolien, Halbleiterwafer oder andere im Wesentlichen plane Behandlungssubstrate handeln.

Die Sprüh-, Schwall- bzw. Hybridätzeinheit 2 dient zum Aufbringen eines Ätzfluids 4 auf eine zu behandelnde, im Wesentlichen plane Oberfläche, im gezeigten Beispiel einer Oberseite 3a des Behandlungssubstrats 3. Die Sprüh-/ Schwall- bzw. Hybridätzeinheit 2 wird daher vorliegend auch Ätzfluid-Aufbringeinheit oder kurz Aufbringeinheit genannt. In alternativen Ausführungsformen kann die Aufbringeinheit 2 unterhalb des Substrattransportniveaus angeordnet sein, um das Behandlungsfluid, hier speziell das Ätzfluid 4, auf eine Unterseite 3b der zu behandelnden Substrate 3 aufzubringen. Je nach Bedarf kann das Ätzmodul 1 auch eine Mehrzahl von Aufbringeinheiten 2 beinhalten, die alle oberhalb oder alle unterhalb oder zum Teil oberhalb und zum Teil unterhalb des Substrattransportniveaus angeordnet sind. Das Behandlungs- bzw. Ätzfluid 4 ist in einem Ätzfluidreservoir 5 bevorratet und wird der jeweiligen Aufbringeinheit 2 über eine Fluidzufuhrleitung 6 zugeführt, in die eine Förderpumpe 7 eingeschleift ist.

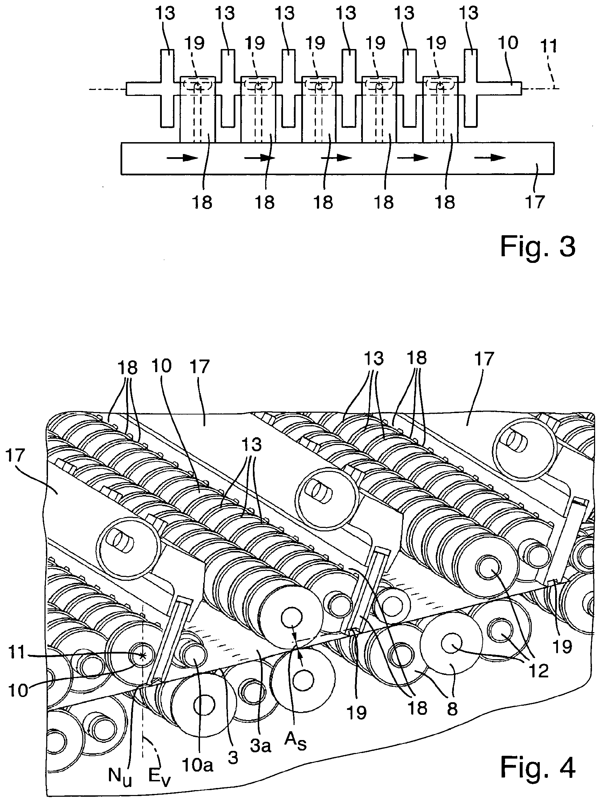

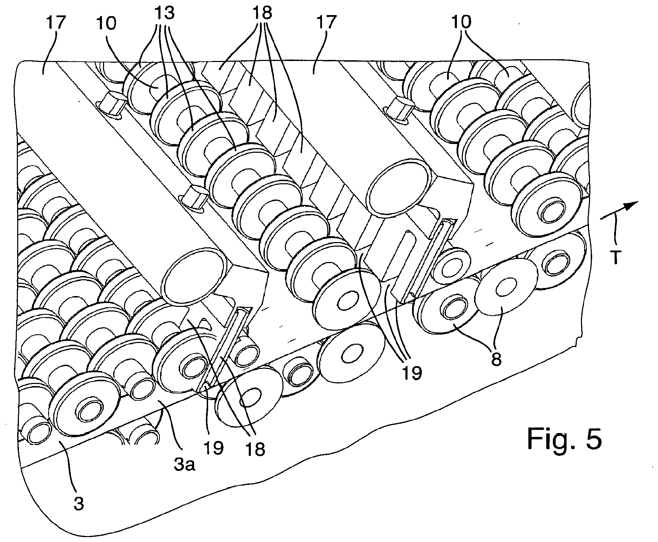

Für die Behandlung, hier die Ätzbehandlung, werden die Behandlungssubstrate 3 in einer im Wesentlichen horizontalen Transportrichtung T mittels einer Transportvorrichtung transportiert, die eine untere Reihe von in Transportrichtung T beabstandet und aufeinanderfolgend angeordneten Transportwalzen 8 beinhaltet, die jeweils um ihre Längsachse 9 drehbar gehalten sind und auf denen die Substrate 3 aufliegen. Im gezeigten Ausführungsbeispiel umfasst die Transportvorrichtung zusätzlich optionale oberseitige Transportwalzen 10, die jeweils den unteren Transportwalzen 8 bezüglich der Transportebene gegenüberliegend angeordnet sind und ebenfalls um ihre Längsachse 11 drehbeweglich gehalten sind. Diese oberen Transportwalzen 10 fungieren als Niederhalter, insbesondere in Anwendungen, bei denen die Behandlungssubstrate 3 relativ dünn sind, zum Beispiel dünne Leiterfolien mit einer Dicke von nur ca. 50 µm oder allgemeiner einer Dicke kleiner als 1mm. Wie aus den Figuren 4 und 5 ersichtlich, sind die unteren und oberen Transportwalzen 8, 10 von einem gleichen Aufbau mit einer zentralen Welle 12 und darauf voneinander beabstandet drehfest angeordneten Transportrollen 13. Transportvorrichtungen dieser Art sind dem Fachmann geläufig, was hier folglich keiner weiteren Erläuterungen bedarf.

Vorzugsweise können für die Aufbringeinheit 4 zur Erzielung guter Ätzresultate Zweistoffdüsen verwendet werden, die das Ätzfluid, d.h. das Ätzmittel, mit einem Gas vermischen. Dies ist insbesondere für Anwendungen zweckmäßig, bei denen vergleichsweise feine Strukturen, d.h. solche mit relativ kleiner Strukturbreite, geätzt werden sollen. Durch das Vermischen mit einem Gas, wie Luft, können relativ kleine Ätzmitteltröpfchen mit hoher Energie auf die Behandlungsoberfläche treffen. Auch dieses sogenannte Hybridätzen ist dem Fachmann an sich geläufig und bedarf daher hier keiner näheren Erläuterungen. Die Zweistoffdüsen haben einen weiteren vorteilhaften Einfluss auf das Ätzmittel, speziell dann, wenn sich dieses durch den Ätzprozess verbraucht und regeneriert werden muss. In der Zweistoffdüse kann das Ätzmittel in engen Kontakt z.B. mit Luft zwecks oxidierender Regeneration gebracht werden, z.B. im Fall eines alkalischen Ätzmediums wie Kupferchlorid. Alternativ oder zusätzlich zu einer solchen Verwendung von Zweistoffdüsen bietet die vorliegende Erfindung die Möglichkeit, das Ätzfluid beim Absaugen von der Behandlungsoberfläche mit Luftsauerstoff zwecks regenerierender Oxidation in Kontakt zu bringen. Dies kann auch den Einsatz eines anderweitigen Regenerationsmittels, wie Wasserstoffperoxid, überflüssig machen oder reduzieren.

In die gezeigte Ätzvorrichtung ist eine Absaugvorrichtung zum Absaugen des Ätzfluids 4 von der Behandlungsoberfläche 3a der Behandlungssubstrate 3 integriert, wobei diese Absaugvorrichtung auch anderweitig zum Absaugen eines beliebigen Behandlungsfluids von einer im Wesentlichen planen Behandlungsoberfläche von Behandlungssubstraten verwendbar ist, die mittels Transportwalzen entlang einer im Wesentlichen horizontalen Transportrichtung transportiert werden. Bei dem Behandlungsfluid kann es sich z.B. außer um ein Ätzfluid auch um ein Reinigungsfluid etc. handeln.

Die Absaugvorrichtung beinhaltet eine Saugquelle 14, eine diese ansteuernde Absaugsteuereinheit 15 und eine an die Saugquelle angeschlossene Absaugrohreinheit mit einer oder mehreren Absauglanzen 16. Beispielsweise können pro Ätzmodul 1 zwischen fünf und zwanzig Absauglanzen 16 vorgesehen sein. Je nach Bedarf und Anwendungsfall kann jeweils eine Absauglanze 16 in Transportrichtung T vor und/oder hinter jeder Behandlungsfluid-Aufbringeinheit 2 angeordnet sein. Die Saugquelle 14 und die Absaugsteuereinheit 15 sind auf die Bereitstellung eines Saugvolumenstroms pro Absauglanze 16 von mindestens 30 m³/h, vorzugsweise von ca. 100 m³/h bis 300 m³/h, und einen Differenzdruck als Saug-Unterdruck von nicht mehr als 8 kPa, vorzugsweise von z.B. zwischen 2kPa und 3kPa ausgelegt.

Die jeweilige Absauglanze 16 weist eine kammartige Absaugstruktur mit einem Absaugsammelrohr 17 und mehreren von diesem kammartig abgehenden Absaugrohren 18 auf, die eintrittsseitig mit je einer oder mehreren Absaugdüsenöffnungen 19 versehen sind. Bevorzugt hat das Sammelrohr 17 einen effektiven Querschnitt, der deutlich größer ist als die Summe der effektiven Querschnitte der in selbiges einmündenden Absaugrohre 18. Die Sammelrohre 17 der Absauglanzen 16 münden in einen gemeinsamen Sammeltank 20, welcher der Saugquelle 14 vorgeschaltet ist. Ein effektiver Strömungsquerschnitt des Sammeltanks 20 ist so gewählt, dass er größer als ein effektiver Strömungsquerschnitt der darin einmündenden Sammelrohre 17 bzw. Absauglanzen 16 ist, vorzugsweise mindestens doppelt so groß und bevorzugter mehr als fünfmal so groß. Dadurch kann der Sammeltank 20 das Abtrennen des angesaugten Fluids von den gasförmigen Bestandteilen des Saugstroms unterstützen. Als optionale Maßnahme ist es vorteilhaft, wenn das Absaugsammelrohr 17 der jeweiligen Absauglanze 16 mit einem Gefälle in Richtung des Sammeltanks 20 angeordnet ist, was den Transport des abgesaugten Fluids im Sammelrohr 17 unterstützt bzw. sicherstellt. Zweckmäßig kann vorgesehen sein, dass der Sammeltank 20 auf einem Niveau oberhalb eines maximalen Flüssigkeitspegels des Behandlungsfluids 4 im Reservoir 5 angeordnet ist. Das im Sammeltank 20 gesammelte Behandlungsfluid kann dann wie gezeigt allein durch Schwerkraft über eine zugehörige Rückleitung 21 wieder in das Reservoir 5 zurückfließen, obwohl im Sammeltank 20 ein Unterdruck herrscht.

Zwischen dem Sammeltank 20 und der Saugquelle 14 kann ein Kondensatabscheider 22 angeordnet sein. Weiter optional ist die Saugquelle 14 mit einem Spülleitungseingang 23 und einem Spülleitungsausgang 24 in eine Spülleitung 25 eingeschleift, wodurch die Saugquelle 14 bei Bedarf gespült werden kann. Für das verwendete Spülfluid, z.B. Spülwasser, kann bei Bedarf eine Rückführung vorgesehen sein. Um eine ausgeglichene Druckbalance innerhalb des Ätzmoduls 1 sicherzustellen, ist optional eine Rückführleitung 26 von der Saugquelle 14 zum Ätzmodul 1 geführt.

Durch die erwähnte Systemauslegung der Absaugvorrichtung und speziell der Saugquelle 14 und der Absaugsteuereinheit 15 auf relativ hohen Saugvolumenstrom bei relativ niedrigem Differenzdruck arbeitet die Absaugvorrichtung nach dem Prinzip der Strömungsgeschwindigkeit. Dabei wird durch den hohen Volumenstrom in Verbindung mit einem geeignet geringen Absaugabstand der Absaugdüsenöffnungen 19 von der mit dem abzusaugenden Fluid 4 belegten Behandlungsoberfläche 3a eine hohe Saugströmungsgeschwindigkeit und damit ein Saugdüseneffekt erzielt, durch den das Behandlungsfluid/Luft-Gemisch mitgerissen und abgesaugt wird. Der geringfügige Unterdruck wird bei diesem Absaugprinzip nicht primär zum Absaugen benötigt, sondern vor allem dazu, das abgesaugte Fluid über die vorhandene Höhendifferenz gegen den hydrostatischen Druck zu transportieren. Gegenüber der herkömmlichen Methode, das Fluid mit hohem Unterdruck bei geringem Volumenstrom abzusaugen, hat diese Methode den signifikanten Vorteil, dass der Absaugvorgang auch dann in ausreichender Weise vonstattengeht, wenn sich die Absauglanze 16 mit ihren Absaugdüsenöffnungen 19 nicht vollständig im Fluid befindet und dadurch zusätzlich Luft ansaugt. Bei der herkömmlichen Methode führt dies durch den zusammenbrechenden Unterdruck zu einem deutlichen Abfall der Saugleistung, während mit der vorliegend benutzten Absaugmethode die Saugleistung durch unterschiedliche Medien mit unterschiedlichen Dichten, wie Behandlungsfluid und Luft, nicht wesentlich beeinflusst wird. Analog wird die Saugleistung auch durch etwaige Lücken zwischen zwei aufeinanderfolgenden Substraten 3 oder durch Leerräume bei Behandlung von Substraten 3 unterschiedlicher Breite nicht störend beeinträchtigt.

Als Saugquelle 14 ist insbesondere ein Radialventilator oder ein Seitenkanalverdichter oder ein ähnlicher herkömmlicher Lüfter verwendbar, der für den besagten Volumenstrom geeignet ist. Soweit in den Figuren Pfeile gezeigt und nicht anderweitig bezeichnet sind, repräsentieren sie den dort jeweils geführten Strom, wie den Saugstrom, den Ätzmittelzufuhrstrom bzw. den Spülfluidstrom.

Durch die kammartige Absaugstruktur lassen sich, wie im gezeigten Ausführungsbeispiel realisiert, die vom Absaugsammelrohr 17 abgehenden Absaugrohre 18 in Zwischenräumen zwischen den Transportrollen 13 einer jeweiligen Transportwalze, hier einer jeweiligen oberen Transportwalze 10, anordnen, wie dies insbesondere aus den Fig. 3 bis 5 zu erkennen ist. Dabei enden die Absaugrohre 18 mit ihren Absaugdüsenöffnungen 19 in einem vorgebbaren Absaugabstand Aₛ zur Behandlungsoberfläche 3a über einem unteren Niveau Nᵤ dieser Transportrollen 13 und in einer durch die Drehachse 11 der betreffenden Transportwalze 10 gehenden Vertikalebene Eᵥ oder in einem Horizontalbstand von höchstens 10mm von dieser Vertikalebene Eᵥ. Zusätzlich oder alternativ können die Absaugrohre 18 mit ihren Absaugdüsenöffnungen 19 so angeordnet sein, dass sie in einem Abstand von höchstens 7mm über dem unteren Niveau Nᵤ dieser Transportrollen 13 enden, wobei sich die Absaugrohre 18 vom auf höherem Niveau liegenden Sammelrohr 17 aus vertikal oder schräg nach unten in die Zwischenräume zwischen den Transportrollen 13 der jeweiligen Transportwalze 10 erstrecken. Wenn wie im gezeigten Beispiel die oberen Transportwalzen 10 mit ihren Transportrollen 13 als Niederhalter für die Behandlungssubstrate 3 fungieren, entspricht das untere Niveau Nᵤ dieser Transportrollen 13 im Wesentlichen dem Niveau der zu behandelnden Substratoberseite 3a, so dass der vertikale Abstand der Absaugdüsenöffnungen 19 vom unteren Transportrollenniveau Nᵤ deren Absaugabstand Aₛ zur Behandlungsoberfläche 3a entspricht. Ein geringer Absaugabstand Aₛ erhöht die Saugstromgeschwindigkeit und begünstigt dadurch das Saugergebnis.

Das Anordnen der Absaugrohre 18 mit ihren Absaugdüsenöffnungen 19 zwischen den Transportrollen 13 von wenigstens einem Teil der oberen Transportwalzen 10 und mit allenfalls geringem Abstand vom tiefsten Punkt dieser Transportrollen 13 und allenfalls geringem horizontalem Abstand von der Vertikalmittenebene Eᵥ dieser Transportwalze 10 in Transportrichtung T begünstigt ein gutes Absaugen des Behandlungsfluids 4 von der Behandlungsoberfläche 3a und vermeidet gleichzeitig ein Anhaften der Substrate 3 aufgrund des Saug-Unterdrucks. Denn an dieser Stelle direkt im Bereich des tiefsten Punktes zwischen den Transportrollen 13 einer jeweiligen oberen Transportwalze 10 wird das Substrat 3 von den Transportrollen 13 niedergehalten und kann sich nicht zu den Absaugdüsenöffnungen 19 hin bewegen. Bei beengten Platzverhältnissen kann es, wie gezeigt, zweckmäßig sein, eine der jeweiligen Absauglanze 16 benachbarte Transportwalze als gegenüber den anderen Transportwalzen 10 modifizierte Transportwalze 10a mit geringerem Durchmesser auszuführen.

Die Absauglanzen 16 können in fester Verbindung am Ätz- bzw. Behandlungsmodul 1 gehalten sein. In einer vorteilhaften alternativen Ausführung sind sie höhenverstellbar im Behandlungsmodul 1 angeordnet. Vorzugsweise können sie dabei mit einer Substratvorschubsteuerung derart gekoppelt sein, dass automatisch Behandlungssubstrate 3 unterschiedlicher Dicke bei im Wesentlichen gleichbleibendem Absaugabstand der Absaugdüsenöffnungen 19 zur Behandlungsoberfläche 3a prozessiert werden können, ohne dass dazu die jeweilige Absauglanze 16 von Hand verstellt werden muss. Stattdessen wird die Absauglanze 16 dann von der betreffenden Steuerung abhängig von der jeweils anstehenden Behandlungssubstratdicke höhenverstellt, die z.B. sensorisch erfasst werden kann. Dies kann z.B. synchron mit einer entsprechenden Höhenverstellung der als Niederhalter fungierenden oberen Transportwalzen 10 erfolgen. In einer diesbezüglich vorteilhaften Ausführung ist die jeweilige Absauglanze 16 fest an der jeweiligen höhenverstellbaren oberen Transportwalze 10 montiert, so dass sie automatisch mit dieser höhenverstellt wird, wenn sich die Dicke der Behandlungssubstrate 3 ändert.

Je nach Bedarf und Anwendungsfall können in die Absaugsteuereinheit 15 neben der bloßen Steuerung der Saugquelle 14 weitere Absaugsteuerungsmaßnahmen implementiert sein. So können z.B. optional Ventile in die Absauglanzen 16 an geeigneter Stelle eingebaut sein, und die Anwesenheit eines zu behandelnden Substrats 3 kann sensorisch überwacht werden. Die Absaugsteuereinheit 15 kann dann die Ventile in den Absauglanzen 16 derart ansteuern, dass die Absauglanze 16 nur in den Zeiträumen saugaktiv ist, in denen sich unter ihren Absaugdüsenöffnungen 19 ein Behandlungssubstrat 3 befindet. Als weitere Option können in den Absauglanzen 16 an geeigneter Stelle Drosseln eingebaut sein, die manuell oder gesteuert über die Absaugsteuereinheit 15 verstellbar sind, um in den einzelnen Absaugdüsenöffnungen 19 die gleiche Absaugleistung einzustellen. In ähnlicher Weise kann vorgesehen sein, die Aufbringeinheiten 2 über Ventile gezielt zu aktivieren und zu deaktivieren. Dadurch lässt sich der Ätzvorgang sehr gezielt lokal einstellen beziehungsweise beeinflussen.

Wie die gezeigten und oben erläuterten Ausführungsformen deutlich machen, stellt die Erfindung in sehr vorteilhafter Weise eine Absaugvorrichtung zur Verfügung, mit der sich ein Behandlungsfluid von einer im Wesentlichen planen Behandlungsoberfläche eines im Wesentlichen horizontal transportierten Behandlungssubstrats absaugen lässt, wobei das Behandlungsfluid insbesondere ein Ätzfluid oder ein Reinigungsfluid sein kann und die Behandlungssubstrate insbesondere Halbleiterwafer, Leiterplatten, Leiterfolien bestimmter Abmessung oder Endlos-Leiterfolien sein können. Die Absaugvorrichtung ist besonders vorteilhaft in einer Ätzvorrichtung zum nasschemischen Ätzen solcher Behandlungssubstrate verwendbar.

## Patentansprüche

1. Absaugvorrichtung zum Absaugen eines Behandlungsfluids (4), insbesondere eines Ätzfluids, von einer im Wesentlichen planen Behandlungsoberfläche (3a) von mittels Transportwalzen (8, 10) entlang einer im Wesentlichen horizontalen Transportrichtung (T) transportierten Behandlungssubstraten (3), insbesondere Leiterplatten oder Leiterfolien oder Halbleiterwafer, mit
- einer Saugquelle (14),
- einer die Saugquelle ansteuernden Absaugsteuereinheit (15) und
- einer an die Saugquelle angeschlossenen Absaugrohreinheit mit wenigstens einer Absauglanze (16), die mit einer oder mehreren eintrittsseitigen Absaugdüsenöffnungen (19) in einem Absaugabstand (Aₛ) zur Behandlungsoberfläche positionierbar ist,
**dadurch gekennzeichnet, dass**
- die Saugquelle (14) und die Absaugsteuereinheit (15) auf einen Saugvolumenstrom pro Absauglanze von mindestens 30m³/h und einen Saug-Unterdruck von nicht mehr als 8kPa ausgelegt sind.

2. Absaugvorrichtung nach Anspruch 1, weiter **dadurch gekennzeichnet, dass** die Absauglanze (16) eine kammartige Absaugstruktur mit einem Absaugsammelrohr (17) und mehreren von diesem kammartig abgehenden Absaugrohren (18) aufweist, die eintrittsseitig die Absaugdüsenöffnungen (19) aufweisen.

3. Absaugvorrichtung nach Anspruch 2, weiter **dadurch gekennzeichnet, dass** sich die Absaugrohre der kammartigen Absaugstruktur vom Absaugsammelrohr aus in Zwischenräume zwischen Transportrollen (13) einer der Transportwalzen hinein erstrecken, die im Abstand voneinander auf der Transportwalze angeordnet sind.

4. Absaugvorrichtung nach Anspruch 3, weiter **dadurch gekennzeichnet, dass** die Absaugrohre mit ihren Absaugdüsenöffnungen im Absaugabstand zur Behandlungsoberfläche über einem unteren Niveau (Nᵤ) der Transportrollen und in einer durch eine Drehachse (11) der Transportwalze gehenden Vertikalebene (Eᵥ) oder um höchstens 10mm von dieser Vertikalebene beabstandet enden.

5. Absaugvorrichtung nach Anspruch 3 oder 4, weiter **dadurch gekennzeichnet, dass** die Absaugrohre mit ihren Absaugdüsenöffnungen in einem Abstand von höchstens 7mm über einem unteren Niveau (Nᵤ) der Transportrollen enden.

6. Absaugvorrichtung nach einem der Ansprüche 1 bis 5, weiter **dadurch gekennzeichnet, dass** die Saugquelle einen Radialventilator oder einen Seitenkanalverdichter umfasst.

7. Absaugvorrichtung nach einem der Ansprüche 1 bis 6, weiter **dadurch gekennzeichnet, dass** die Saugquelle mit einem Spülleitungseingang (23) und einem Spülleitungsausgang (24) in eine Spülleitung (25) eingeschleift ist.

8. Absaugvorrichtung nach einem der Ansprüche 1 bis 7, weiter **gekennzeichnet durch** einen Behandlungsmedium-Sammeltank (20), der an einem Eingang mit der wenigstens einen Absauglanze und an einem Ausgang mit der Saugquelle verbunden ist und der einen effektiven Strömungsquerschnitt aufweist, der größer als ein effektiver Strömungsquerschnitt der darin einmündenden wenigstens einen Absauglanze ist.

9. Absaugvorrichtung nach Anspruch 8, weiter **dadurch gekennzeichnet, dass** das Absaugsammelrohr der jeweiligen Absauglanze mit einem Gefälle in Richtung des Behandlungsmedium-Sammeltanks angeordnet ist.

10. Ätzvorrichtung zum nasschemischen Ätzen einer im Wesentlichen planen Behandlungsoberfläche (3a) von Behandlungssubstraten (3), insbesondere von Leiterplatten oder Leiterfolien oder Halbleiterwafer, mittels eines Ätzfluids (4), mit
- mindestens einem Ätzmodul (1) mit einem Ätzfluidreservoir (5),
- Ätzfluid-Fördermitteln (2, 6, 7) zum Fördern des Ätzfluids vom Ätzfluidreservoir zur Behandlungsoberfläche,
- einer Transporteinheit mit Transportwalzen (8, 10) zum Transportieren der Behandlungssubstrate entlang einer im Wesentlichen horizontalen Transportrichtung (T) und
- einer Absaugvorrichtung zum Absaugen des Ätzfluids von der Behandlungsoberfläche,
**dadurch gekennzeichnet, dass**
- die Absaugvorrichtung eine solche nach einem der Ansprüche 1 bis 9 ist.

11. Ätzvorrichtung nach Anspruch 10, weiter **dadurch gekennzeichnet, dass** der Ätzfluid-Sammeltank der Absaugvorrichtung auf einem Niveau über dem Ätzfluidreservoir angeordnet ist und eine Rückführleitung (21) vom Ätzfluid-Sammeltank zum Ätzfluidreservoir führt.

## Claims

1. Suction-extraction apparatus for extracting a treatment fluid (4), in particular an etching fluid, by suction from an essentially planar treatment surface (3a) of treatment substrates (3), in particular printed circuit boards or conductor foils or semiconductor wafers, transported by means of transporting rollers (8, 10) along an essentially horizontal transporting direction (T), having
- a suction source (14),
- a suction-extraction-control unit (15), which activates the suction source, and
- a suction-extraction-tube unit, which is connected to the suction source and has at least one suction-extraction lance (16), which can have one or more entry-side suction-extraction-nozzle openings (19) positioned at a suction-extraction distance (Aₛ) from the treatment surface,
**characterized in that**
- the suction source (14) and the suction-extraction-control unit (15) are designed for a suction-volume flow per suction-extraction lance of at least 30 m³/h and a negative suction pressure of no more than 8 kPa.

2. Suction-extraction apparatus according to Claim 1, further **characterized in that** the suction-extraction lance (16) has a comb-like suction-extraction structure with a suction-extraction-collecting tube (17) and a plurality of suction-extraction tubes (18) which extend in a comb-like manner from said collecting tube and have the suction-extraction-nozzle openings (19) on the entry side.

3. Suction-extraction apparatus according to Claim 2, further **characterized in that** the suction-extraction tubes of the comb-like suction-extraction structure extend from the suction-extraction-collecting tube into interspaces between transporting-roller members (13) of one of the transporting rollers, said members being spaced apart from one another on the transporting roller.

4. Suction-extraction apparatus according to Claim 3, further **characterized in that** the suction-extraction tubes have their suction-extraction-nozzle openings terminating at the suction-extraction distance from the treatment surface above a lower level (Nᵤ) of the transporting-roller members and in a vertical plane (Eᵥ) which passes through an axis of rotation (11) of the transporting roller, or are spaced apart from said vertical plane by at most 10 mm.

5. Suction-extraction apparatus according to Claim 3 or 4, further **characterized in that** the suction-extraction tubes have their suction-extraction-nozzle openings terminating at a distance of at most 7 mm above a lower level (Nᵤ) of the transporting-roller members.

6. Suction-extraction apparatus according to one of Claims 1 to 5, further **characterized in that** the suction source comprises a radial fan or a side-channel blower.

7. Suction-extraction apparatus according to one of Claims 1 to 6, further **characterized in that** the suction source is fitted into a rinsing line (25) by way of a rinsing-line entrance (23) and a rinsing-line exit (24).

8. Suction-extraction apparatus according to one of Claims 1 to 7, further **characterized by** a treatment-medium-collecting tank (20), which is connected at an entrance to the at least one suction-extraction lance and at an exit to the suction source and which has an effective flow cross section which is larger than an effective flow cross section of the at least one suction-extraction lance which opens out into the same.

9. Suction-extraction apparatus according to Claim 8, further **characterized in that** the suction-extraction-collecting tube of the respective suction-extraction lance is arranged with a slope in the direction of the treatment-medium-collecting tank.

10. Etching apparatus for the wet chemical etching of an essentially planar treatment surface (3a) of treatment substrates (3), in particular of printed circuit boards or conductor foils or semiconductor wafers, by means of an etching fluid (4), having
- at least one etching module (1) with an etching-fluid reservoir (5),
- etching-fluid-delivery means (2, 6, 7) for delivering the etching fluid from the etching-fluid reservoir to the treatment surface,
- a transporting unit with transporting rollers (8, 10) for transporting the treatment substrates along an essentially horizontal transporting direction (T), and
- a suction-extraction apparatus for extracting the etching fluid by suction from the treatment surface,
**characterized in that**
- the suction-extraction apparatus is one such according to one of Claims 1 to 9.

11. Etching apparatus according to Claim 10, further **characterized in that** the etching-fluid-collecting tank of the suction-extraction apparatus is arranged at a level above the etching-fluid reservoir and a return line (21) leads from the etching-fluid-collecting tank to the etching-fluid reservoir.

## Revendications

1. Dispositif d'aspiration pour l'aspiration d'un fluide de traitement (4), en particulier un fluide de gravure, d'une surface de traitement (3a) essentiellement plane de substrats de traitement (3), en particulier circuits imprimés ou feuilles conductrices ou tranches de semi-conducteur, transportés au moyen de rouleaux transporteurs (8, 10) le long d'une direction de transport (T) essentiellement horizontale, comprenant
- une source d'aspiration (14),
- une unité de commande d'aspiration (15) activant la source d'aspiration et
- une unité de tuyau d'aspiration raccordée à la source d'aspiration avec au moins une lance d'aspiration (16), qui est positionnable par une ou plusieurs orifices de buse d'aspiration (19) à une distance d'aspiration (Aₛ) de la surface de traitement,
**caractérisé en ce que**
- la source d'aspiration (14) et l'unité de commande d'aspiration (15) sont conçues pour un débit de volume d'aspiration par lance d'aspiration d'au moins 30 m³/h et une pression négative d'aspiration ne pas dépassant 8 kPa.

2. Dispositif d'aspiration selon la revendication 1, **caractérisé en outre en ce que** la lance d'aspiration (16) présente une structure d'aspiration en forme de peigne avec un tube collecteur d'aspiration (17) et plusieurs tuyaux d'aspiration (18) s'étendant en forme de peigne à partir du tube collecteur d'aspiration et présentant les orifices de buse d'aspiration (19) sur le côté d'entrée.

3. Dispositif d'aspiration selon la revendication 2, **caractérisé en outre en ce que** les tuyaux d'aspiration de la structure d'aspiration en forme de peigne s'étendent à partir du tube collecteur d'aspiration dans des espaces intermédiaires entre des roulettes transporteurs (13) d'un des rouleaux transporteurs, lesdites roulettes étant disposées sur le rouleau transporteur espacées l'une de l'autre.

4. Dispositif d'aspiration selon la revendication 3, **caractérisé en outre en ce que** les tuyaux d'aspiration avec leurs orifices de buse d'aspiration se terminent à la distance d'aspiration de la surface de traitement au-dessus d'un niveau inférieur (N_{U}) des rouleaux transporteurs et à un plan vertical (E_{V}) passant au travers d'un axe de rotation (11) du rouleau transporteur ou espacés au maximum de 10 mm dudit plan vertical.

5. Dispositif d'aspiration selon la revendication 3 ou 4, **caractérisé en outre en ce que** les tuyaux d'aspiration avec leurs orifices de buse d'aspiration se terminent à une distance d'au maximum 7 mm au-dessus d'un niveau inférieur (N_{U}) des roulettes transporteurs.

6. Dispositif d'aspiration selon l'une des revendications 1 à 5, **caractérisé en outre en ce que** la source d'aspiration comporte un ventilateur radial ou un souffleur de canal latéral.

7. Dispositif d'aspiration selon l'une des revendications 1 à 6, **caractérisé en outre en ce que** la source d'aspiration est bouclée dans une conduite de rinçage (25) par une entrée de conduite de rinçage (23) et une sortie de conduite de rinçage (24).

8. Dispositif d'aspiration selon l'une des revendications 1 à 7, **caractérisé en outre par** un réservoir collecteur (20) de médium de traitement relié d'une entrée à l'au moins une lance d'aspiration et d'une sortie à la source d'aspiration et présente une section d'écoulement effective supérieure à une section d'écoulement effective de l'au moins une lance d'aspiration se dégorgeant dedans.

9. Dispositif d'aspiration selon la revendication 8, **caractérisé en outre en ce que** le tube collecteur d'aspiration de la lance d'aspiration respective est arrangée en pente dans la direction vers le réservoir collecteur de médium de traitement.

10. Dispositif de gravure pour la gravure chimique humide d'une surface de traitement (3a) essentiellement plane de substrats de traitement (3), en particulier de circuits imprimés ou feuilles conductrices ou tranches de semi-conducteur, au moyen d'un fluide de gravure (4), avec
- au moins un module de gravure (1) comprenant un réservoir de fluide de gravure (5),
- des moyens transporteurs (2, 6, 7) de fluide de gravure pour alimenter le fluide de gravure du réservoir de fluide de gravure à la surface de traitement,
- une unité de transport comprenant rouleaux transporteurs (8, 10) pour transporter les substrats de traitement le long d'une direction de transport (T) essentiellement horizontale et
- un dispositif d'aspiration pour l'aspiration du fluide de gravure de la surface de traitement,
**caractérisé en ce que**
- le dispositif d'aspiration est un tel dispositif selon l'une des revendications 1 à 9.

11. Dispositif de gravure selon la revendication 10, **caractérisé en outre en ce que** le réservoir collecteur de fluide de gravure du dispositif d'aspiration est disposé à un niveau au-dessus du réservoir de fluide de gravure et un conduit de retour (21) mène du réservoir collecteur de fluide de gravure au réservoir de fluide de gravure.
